# EUROPÄISCHE PATENTSCHRIFT

(11) **EP 3 155 700 B1**
(45) Veröffentlichungstag und Bekanntmachung des Hinweises auf die Patenterteilung: **11.07.2018**
(21) Anmeldenummer: 15730739.8
(22) Anmeldetag: 15.06.2015
(51) Int. Cl.: H01R 43/20

(54) **VORRICHTUNG UND VERFAHREN ZUM AUTOMATISCHEN BESTÜCKEN EINES STECKERGEHÄUSES**
METHOD AND DEVICE FOR ASSEMBLING A CONNECTOR HOUSING
PROCÉDÉ ET DISPOSITIF D'ASSEMBLAGE D'UN BOÎTIER DE CONNEXION

(30) Priorität: 16.06.2014 EP 14172588
(43) Veröffentlichungstag der Anmeldung: 19.04.2017
(73) Patentinhaber: Delphi Technologies, Inc., Troy, MI 48007 (US)
(72) Erfinder: LARISCH, Markus, 42327 Wuppertal (DE)
(74) Vertreter: Robert, Vincent
(86) Internationale Anmeldenummer: PCT/EP2015/063350
(87) Internationale Veröffentlichungsnummer: WO 2015/193248

(56) Entgegenhaltungen:
- EP-A1- 2 461 433
- US-A- 6 043 877
- US-A1- 2009 199 396

## Beschreibung

Die vorliegende Erfindung betrifft ein Verfahren zum automatischen Bestücken eines Steckergehäuses mit einem an einer elektrischen Leitung angebrachten Kontaktteil, wobei das Steckergehäuse an einem Halter fixiert wird und das Kontaktteil mittels eines beweglichen Greifers in eine Kavität des Steckergehäuses eingeführt wird.

Das maschinelle Fertigen von elektrischen Leitungssätzen wird häufig unter Verwendung von Robotern oder ähnlichen Positioniervorrichtungen durchgeführt, die mit Greifern als Endeffektoren ausgestattet sind. Üblicher Weise hält ein solcher Greifer ein Kontaktteil entweder direkt oder an der elektrischen Leitung, bewegt es zu der gewünschten Kavität und führt es in diese ein. Ein derartiges Bestückungsverfahren ist in der EP 2 461 433 A1 offenbart. Unter dem Begriff "Steckergehäuse" ist grundsätzlich auch ein Buchsengehäuse, eine Klemmleiste oder dergleichen zu verstehen. Um einen zuverlässigen und effizienten Bestückungsprozess zu gewährleisten, ist eine genaue Kenntnis der Positionen der entsprechenden Komponenten des Systems erforderlich.

Aus Kostengründen können weder die Steckergehäuse noch die Kontaktteile üblicher elektrischer Leitungen mit strengen Toleranzvorgaben gefertigt werden. Demgemäß kommt es beim Betrieb gängiger Bestückungsvorrichtungen immer wieder zu Ungenauigkeiten hinsichtlich der Positionierung, wodurch ein zuverlässiger und effizienter Betrieb erschwert wird.

Es ist eine Aufgabe der Erfindung, auch bei Verwendung von toleranzbehafteten Positioniervorrichtungen, Steckergehäusen, Haltern und/oder Kontaktteilen ein präzises, fehlerfreies und schnelles Bestücken eines Steckergehäuses mit einem an einer elektrischen Leitung angebrachten Kontaktteil zu ermöglichen.

Die Lösung der Aufgabe erfolgt durch ein Verfahren mit den Merkmalen des Anspruchs 1.

Erfindungsgemäß wird vor dem Einführen des Kontaktteils in die Kavität ein Ausrichtprozess durchgeführt, welcher folgende Schritte umfasst:
(i) Halten des Kontaktteils, direkt oder an der elektrischen Leitung, mittels des Greifers oder eines weiteren Greifers,
(ii) Ermitteln einer tatsächlichen Drehstellung des gehaltenen Kontaktteils in Bezug auf eine parallel zu einer Einführrichtung verlaufende Rotationsachse,
(iii) Vergleichen der ermittelten tatsächlichen Drehstellung mit einer durch die Beschaffenheit und die Anordnung des Steckergehäuses vorgegebenen Drehstellung, und
(iv) Durchführen einer Drehstellungskorrektur mittels des das Kontaktteil haltenden Greifers beruhend auf dem Ergebnis des Vergleichs.

Durch den Ausrichtprozess wird sichergestellt, dass sich jedes bereitgestellte Kontaktteil vor dem Einführprozess in der korrekten Drehstellung befindet. Somit können individuelle Lageabweichungen ausgeglichen und die Prozess-Sicherheit erhöht werden. Insbesondere ist es möglich, radiale Gestaltmerkmale eines Kontaktteils, wie zum Beispiel Crimpnasen, Abflachungen, Vertiefungen oder dergleichen, in die durch die Form der Kavität vorgegebene Position zu bringen. Durch die automatische Drehstellungskorrektur kann die Zuverlässigkeit des Bestückungsvorgangs beträchtlich erhöht werden.

Vorzugsweise wird das Ermitteln der tatsächlichen Drehstellung des Kontaktteils in Schritt (ii) mittels einer auf das gehaltene Kontaktteil gerichteten Bilderfassungseinrichtung durchgeführt. Bei der Bilderfassungseinrichtung kann es sich insbesondere um eine Kamera mit einem dieser zugeordneten Bildverarbeitungssystem handeln. Der Einsatz einer Bilderfassungseinrichtung ermöglicht eine berührungsfreie und schnelle Erfassung der Drehstellung eines Kontaktteils.

Vorzugsweise wird ein Objektiv der Bilderfassungseinrichtung auf eine der elektrischen Leitung abgewandte Stirnseite des gehaltenen Kontaktteils fokussiert. Dies gewährleistet eine optimale Erkennbarkeit von radialen Gestaltmerkmalen oder Markierungen des Kontaktteils in einem erfassten Bild.

Eine Ausführungsform der Erfindung sieht vor, dass der Ausrichtprozess ferner den folgenden Schritt umfasst:
(v) Durchführen einer Tiefenstellungskorrektur mittels des das Kontaktteil haltenden Greifers, falls eine tatsächliche Tiefenstellung des gehaltenen Kontaktteils, welche eine bezüglich der Rotationsachse axiale Position einer der elektrischen Leitung abgewandten Stirnseite des Kontaktteils angibt, von einer vorgegebenen Referenz-Tiefenstellung abweicht.

Abweichungen der tatsächlichen Tiefenstellung von der vorgegebenen Referenz-Tiefenstellung können insbesondere aufgrund toleranzbedingter Längenunterschiede der einzelnen bereitgestellten Kontaktteile auftreten. Im Rahmen der Erfindung wurde erkannt, dass derartige Abweichungen häufig zu kritischen Fehlpositionierungen von Kontaktteilen in den zugehörigen Kavitäten führen. Durch eine automatische Tiefenstellungskorrektur können solche Fehlstellungen verhindert werden. Der Abstand zwischen dem das Kontaktteil haltenden Greifer und der Kontaktteilspitze ist durch die überstehende Leitungslänge und die Länge des Kontaktteils gegeben. Diese beiden Längen sind im Allgemeinen prozessbedingt bekannt und können entsprechend berücksichtigt werden, damit beim nachfolgenden Bestückungsvorgang der Abstand zwischen dem Greifer und der Kontaktteilspitze stets konstant ist.

Gemäß der Erfindung wird das Halten des Kontaktteils in Schritt (i) sowie das Durchführen der Drehstellungskorrektur in Schritt (iv) mittels eines drehbaren Ausrichtgreifers durchgeführt, der von dem zum Einführen des Kontaktteils in die Kavität vorgesehenen Greifer getrennt ist, wobei das Kontaktteil nach dem Durchführen der Drehstellungskorrektur in Schritt (iv) unter Vermeidung einer weiteren Verdrehung von dem Ausrichtgreifer an den zum Einführen des Kontaktteils in die Kavität vorgesehenen Greifer übergeben wird. Aufgrund des Bereitstellens eines separaten Greifers für den Ausrichtprozess ist der zum Bestücken vorgesehene Greifer von dem Ausrichtvorgang nicht betroffen und kann dementsprechend aufeinanderfolgende Bestückungsvorgänge ohne Verzögerung ausführen. Somit wird die Effizienz der Gesamtanlage durch den Ausrichtprozess nicht beeinträchtigt.
Vorzugsweise werden das Einführen des Kontaktteils in die Kavität einerseits und der Ausrichtprozess andererseits an räumlich voneinander getrennten Stationen einer gemeinsamen Bestückungsvorrichtung durchgeführt, um einen effizienten Gesamtprozess zu gewährleisten.
Insbesondere kann während des Durchführens des Ausrichtprozesses an der einen Station ein zuvor ausgerichtetes Kontaktteil an der anderen Station in eine Kavität eines Steckergehäuses eingeführt werden. Der Durchsatz einer Bestückungsanlage kann hierdurch gesteigert werden.
Eine weitere Ausführungsform der Erfindung sieht vor, dass während des Durchführens des Ausrichtprozesses ein nachfolgend auszurichtendes weiteres an einer elektrischen Leitung angebrachtes Kontaktteil mittels eines beweglichen Zuführungsgreifers von einer Kontaktteilzufuhr entnommen und in eine Bereitstellungsposition gebracht wird. Hierdurch kann der Gesamtprozess weiter beschleunigt werden, da der Zuführungsgreifer das Kontaktteil bereits vorpositioniert dem Ausrichtprozess zuführen kann.

Gemäß einer speziellen Ausgestaltung der Erfindung werden in Schritt (i) mittels eines Mehrfachgreifers wenigstens zwei Kontaktteile gleichzeitig gehalten, welche in Schritt (iv) mittels des Mehrfachgreifers einer gemeinsamen Drehstellungskorrektur unterzogen werden. Insbesondere kann ein Doppelgreifer vorgesehen sein. Ein derartiger Doppelgreifer ermöglicht einen besonders schnellen Bestückungsprozess - insbesondere in dem Fall, in welchem eine elektrische Leitung mit an beiden Enden befestigten Kontaktteilen zur Verbindung zweier Steckergehäuse zu montieren ist.

Die Erfindung betrifft auch eine Vorrichtung zum automatischen Bestücken eines Steckergehäuses mit einem an einer elektrischen Leitung angebrachten Kontaktteil, umfassend einen Halter zum Fixieren des Steckergehäuses und einen beweglichen Greifer zum Einführen des Kontaktteils in eine Kavität des Steckergehäuses.

Zur Lösung der oben angegebenen Aufgabe umfasst eine erfindungsgemäße Bestückungsvorrichtung eine Ausrichtstation, welche umfasst:
- wenigstens einen Ausrichtgreifer, welcher zum Halten des Kontaktteils, direkt oder an der elektrischen Leitung, und zum Drehen des gehaltenen Kontaktteils um eine parallel zu einer Einführrichtung verlaufende Rotationsachse ausgebildet ist;
- eine Bilderfassungseinrichtung zum Ermitteln einer tatsächlichen Drehstellung eines von dem Ausrichtgreifer gehaltenen Kontaktteils in Bezug auf die Rotationsachse; und
- eine Steuereinrichtung, welche dazu ausgebildet ist, die ermittelte tatsächliche Drehstellung mit einer durch die Beschaffenheit und Anordnung des Steckergehäuses vorgegebenen Drehstellung zu vergleichen und den Ausrichtgreifer derart anzusteuern, dass dieser beruhend auf dem Ergebnis des Vergleichs eine korrigierende Drehbewegung ausführt.

Durch Vorsehen einer Ausrichtstation mit Ausrichtgreifer und Bilderfassungseinrichtung kann bei einer automatischen Bestückungsvorrichtung die Prozesssicherheit erhöht und die Effizienz gesteigert werden. Die Ausrichtstation kann insbesondere einer Bestückungsstation prozesstechnisch vorgeschaltet sein.

Bevorzugt ist der Ausrichtgreifer zusätzlich zu dem zum Einführen des Kontaktteils in die Kavität vorgesehenen Greifer vorgesehen. Somit ist der zum Bestücken vorgesehene Greifer durch die Drehstellungskorrektur nicht belastet.

Der Ausrichtgreifer kann zum Drehen des gehaltenen Kontaktteils um wenigstens 90°, bevorzugt um wenigstens 180°, ausgebildet sein. Dies ermöglicht eine Drehstellungskorrektur auch bei vergleichsweise groben Fehlstellungen bzw. aus beliebigen Anfangsstellungen. Insbesondere erleichtert eine Drehbarkeit des Greifers in einem derart weiten Drehwinkelbereich das Positionieren von einzelnen radialen Gestaltmerkmalen des Kontaktteils, wie zum Beispiel Crimpnasen, Abflachungen, Vertiefungen und dergleichen.

Gemäß einer Ausführungsform der Erfindung ist der Ausrichtgreifer entlang der Rotationsachse und/oder rechtwinklig zu der Rotationsachse verschiebbar, vorzugsweise mittels eine Linear-Positionierungssystems. Die Korrekturmöglichkeiten beim Ausrichtprozess können hierdurch erweitert werden. Der Vorteil eines Linear-Positionierungssystems im Vergleich zu einem Roboter besteht darin, dass keine Rechenmodell-bedingten Nichtlinearitäten auftreten.

Gemäß einer speziellen Ausgestaltung ist der Ausrichtgreifer zum gemeinsamen Halten und Drehen von wenigstens zwei Kontaktteilen ausgebildet, insbesondere wobei jedem der gehaltenen Kontaktteile eine eigene Bilderfassungseinrichtung zugeordnet ist. Mehrfachgreifer ermöglichen besonders schnelle Bestückungsvorgänge.

Vorzugsweise ist die Bilderfassungseinrichtung derart angeordnet, dass sie von einer der elektrischen Leitung abgewandten Seite aus auf das von dem Ausrichtgreifer gehaltene Kontaktteil gerichtet ist. Die tatsächliche Drehstellung des Kontaktteils ist von einem derartigen Standpunkt aus besonders gut erkennbar.

Gemäß einem Aspekt der Erfindung ist eine weitere Bilderfassungseinrichtung zum Ermitteln der Position des Steckergehäuses relativ zu einer vorgegebenen Referenzposition vorgesehen, wobei der bewegliche Greifer und die weitere Bilderfassungseinrichtung eine für eine gemeinsame Bewegung ausgebildete Bestückungseinheit bilden. Mit anderen Worten kann also eine Bestückungseinheit mit eigener Bilderfassungseinrichtung vorgesehen sein, sodass keine Vermessungsstation einschließlich zugehöriger Antriebe notwendig ist. Zwischen dem Kamerabild und der Spitze des Kontaktteils am Greifer besteht aufgrund der gemeinsamen Beweglichkeit eine feste geometrische Beziehung. Hierdurch ergibt sich eine hohe Flexibilität hinsichtlich verschiedener Bestückungen einer bestimmten Palette mit Steckergehäusen. Die Vorteile einer Bestückungseinheit mit eigener Bilderfassungseinrichtung bestehen unabhängig von dem Vorhandensein einer Ausrichtstation, sodass für diesen Aspekt auch unabhängig Schutz beansprucht wird.

Weiterbildungen der Erfindung sind auch in den abhängigen Ansprüchen, der Beschreibung sowie der beigefügten Zeichnung angegeben.

Nachfolgend wird die Erfindung beispielhaft unter Bezugnahme auf die Zeichnungen beschrieben.
- Fig. 1: ist eine vereinfachte Darstellung einer erfindungsgemäßen Bestückungsvorrichtung während des Bereitstellens einer elektrischen Leitung einschließlich zweier daran befestigter Kontaktteile.
- Fig. 2: zeigt die Bestückungsvorrichtung gemäß Fig. 1 während der Übergabe der elektrischen Leitung an eine Ausrichtstation.
- Fig. 3: zeigt die Bestückungsvorrichtung gemäß Fig. 1 während eines Ausrichtprozesses.
- Fig. 4: zeigt die Bestückungsvorrichtung gemäß Fig. 1 während der Übergabe der elektrischen Leitung an eine Bestückungsstation.
- Fig. 5: zeigt die Bestückungsvorrichtung gemäß Fig. 1 vor dem Einführen der Kontaktteile in jeweilige Kavitäten von Steckergehäusen.
- Fig. 6: zeigt die Bestückungsvorrichtung gemäß Fig. 1 nach dem Einführen der Kontaktteile in die Kavitäten.
- Fig. 7: zeigt die Bestückungsvorrichtung gemäß Fig. 1 während der Durchführung eines Kalibrierungsprozesses.

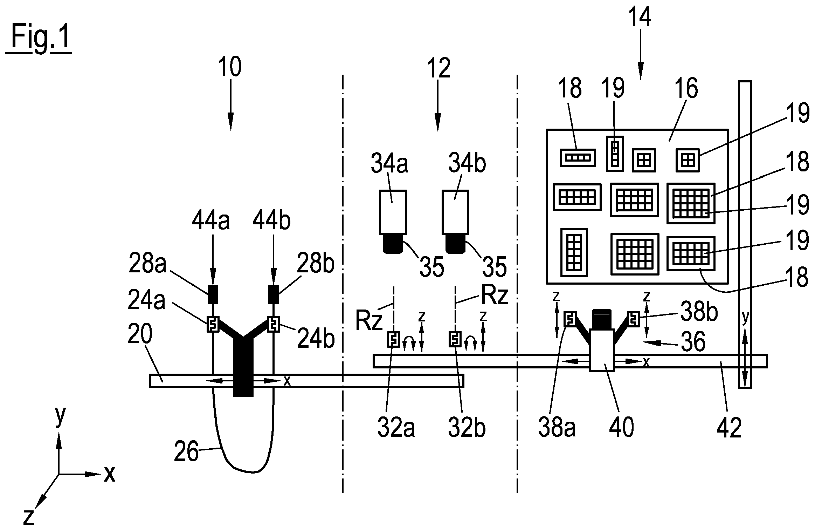

Die in Fig. 1 bis 7 vereinfacht dargestellte Bestückungsvorrichtung umfasst eine Zuführungsstation 10, eine Ausrichtstation 12 und eine Bestückungsstation 14, welche räumlich voneinander getrennt - hier direkt aufeinanderfolgend - angeordnet sind. Im Bereich der Bestückungsstation 14 befindet sich ein ortsfest fixierbarer Halter 16 für mehrere Steckergehäuse 18. Die Steckergehäuse 18 können insbesondere in Aufnahmen des palettenartigen Halters 16 eingerastet sein, gegebenenfalls unter Verwendung zusätzlicher Halterungen. Die beispielhaft in unterschiedlichen Gestaltungen dargestellten Steckergehäuse 18 weisen jeweils mehrere Kavitäten 19 auf.

Ein erstes Positionierungssystem 20, hier in Form eines einachsigen Linearsystems, ist der Zuführungsstation 10 zugeordnet und dient der Bewegung zweier nebeneinander angeordneter Zuführungsgreifer 24a ,24b, die zu einem Doppelgreifer kombiniert sind. In Fig. 1 ist im Bereich der Zuführungsstation 10 eine elektrische Leitung 26 erkennbar, welche an beiden Enden mit jeweiligen Kontaktteilen 28a, 28b versehen ist. Jedes der Kontaktteile 28a, 28b ist an der elektrischen Leitung 26 von einem der Zuführungsgreifer 24a, 24b gehalten. Die Zuführungsgreifer 24a, 24b könnten auch zum direkten Halten der Kontaktteile 28a, 28b ausgebildet sein.

Im Bereich der Ausrichtstation 12 sind zwei nebeneinander angeordnete Ausrichtgreifer 32a, 32b vorgesehen, welche anwendungsabhängig ebenfalls zu einem Doppelgreifer kombiniert sein können. Die Ausrichtgreifer 32a, 32b können im Prinzip ähnlich gestaltet sein wie die Zuführungsgreifer 24a, 24b. Wie durch die gekrümmten Doppelpfeile dargestellt sind die Ausrichtgreifer 32a, 32b jeweils zum Drehen eines gehaltenen Kontaktteils 28a, 28b um eine Rotationsachse Rz drehbar, vorzugsweise um 180°, ausgebildet. Zusätzlich sind die Ausrichtgreifer 32a, 32b jeweils entlang der Rotationsachse Rz linear verschiebbar, wie durch die geraden Doppelpfeile angegeben ist. Zwei Kameras 34a, 34b einschließlich jeweiliger, nicht dargestellter Bildverarbeitungssysteme sind im Bereich der Ausrichtstation 12 angeordnet und auf jeweils einen der Ausrichtgreifer 32a, 32b gerichtet. Die Kameras 34a, 34b könnten auch an ein gemeinsames Bildverarbeitungssystem angeschlossen sein.

Eine der Bestückungsstation 14 zugeordnete Bestückungseinheit 36 umfasst zwei Bestückungsgreifer 38a, 38b sowie eine weitere Kamera 40 mit zugehörigem - eigenem oder übergeordnetem - Bildverarbeitungssystem. Mittels eines zweiten Positionierungssystems 42, das wie dargestellt als zweiachsiges Linearsystem ausgebildet ist, kann die Bestückungseinheit 36 vor die einzelnen an dem Halter 16 fixierten Steckergehäuse 18 bewegt werden. Wie dargestellt überlappen das erste Positionierungssystem 20 und das zweite Positionierungssystem 42 im Bereich der Ausrichtstation 12 miteinander, so dass eine Übergabe von gehaltenen Kontaktteilen 28a, 28b zwischen den einzelnen Greifern möglich ist.

Der Deutlichkeit halber sind in allen Figuren der Halter 16 mit den fixierten Steckergehäusen 18 sowie das zweite Positionierungssystem 42 in einer Vorderansicht dargestellt, während die übrigen Komponenten der Bestückungsvorrichtung in einer Draufsicht dargestellt sind.

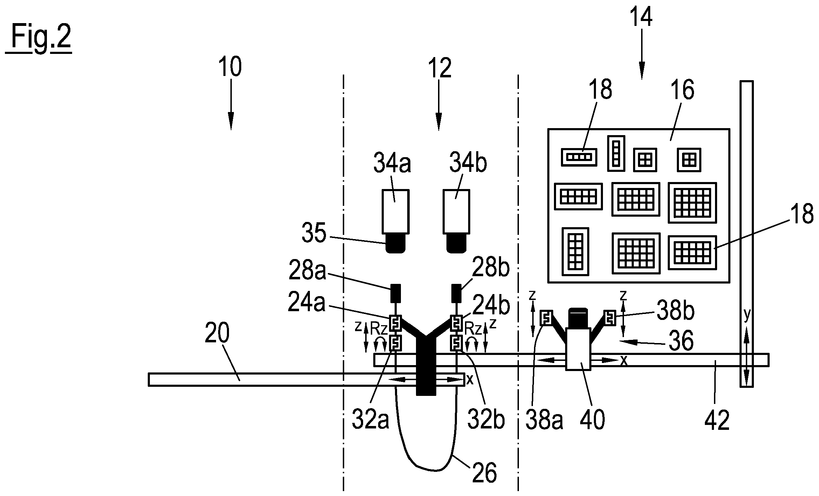

Während eines Normalbetriebs der Bestückungsvorrichtung wird eine vorgefertigte elektrische Leitung 26 mit zwei endseitig angebrachten Kontaktteilen 28a, 28b von einer nicht dargestellten Bauteilzufuhr entnommen und wie in Fig. 1 gezeigt mittels der Zuführungsgreifer 24a, 24b in eine Bereitstellungsposition gebracht. Dabei können Crimpnasen der Kontaktteile 28a, 28b beispielsweise stets nach oben weisen. Die Kontaktteile 28a, 28b werden dann mittels des ersten Positionierungssystems 20 zu der Ausrichtstation 12 bewegt und an die Ausrichtgreifer 32a, 32b übergeben. Diese Übergabe ist in Fig. 2 dargestellt. Nach der Übergabe werden die Zuführungsgreifer 24a, 24b in ihre Ausgangspositionen zurückbewegt und es wird unmittelbar mit der Bereitstellung einer weiteren elektrischen Leitung 26 begonnen.

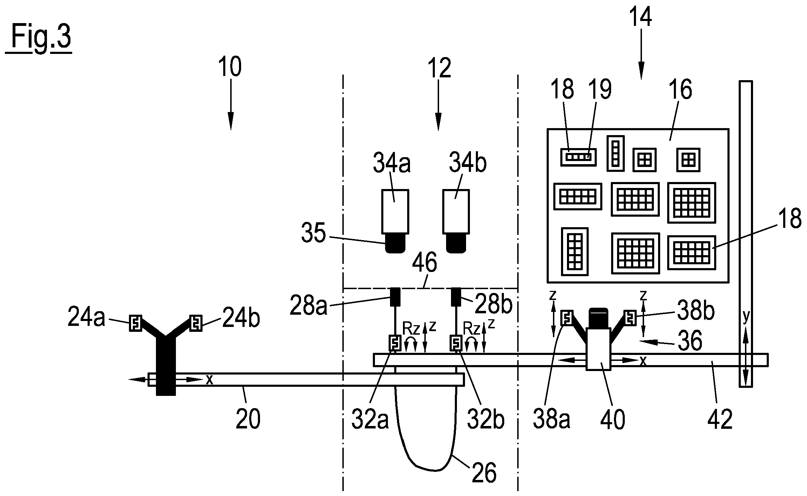

Die Ausrichtgreifer 32a, 32b führen einen Ausrichtprozess durch, indem zunächst mittels der Kameras 34a, 34b und der zugehörigen Bildverarbeitungssysteme eine tatsächliche Drehstellung der gehaltenen Kontaktteile 28a, 28b in Bezug auf die jeweilige Rotationsachse Rz ermittelt wird. Die Objektive 35 der Kameras 34a, 34b werden hierbei jeweils auf die vorderen Stirnseiten 44a, 44b (Fig. 1) der gehaltenen Kontaktteile 28a, 28b fokussiert. Anschließend wird die ermittelte tatsächliche Drehstellung mit einer durch die Beschaffenheit und die Anordnung des zu bestückenden Steckergehäuses 18 vorgegebenen Drehstellung verglichen. Anhand des Ergebnisses des Vergleichs wird eine Drehstellungskorrektur durch entsprechendes Verdrehen der Ausrichtgreifer 32a, 32b durchgeführt. Zusätzlich werden die beiden Kontaktteile 28a, 28b bedarfsweise mittels der Ausrichtgreifer 32a, 32b derart entlang der jeweiligen Rotationsachse Rz verschoben, dass die vorderen Stirnseiten 44a, 44b der Kontaktteile 28a, 28b auf einer gemeinsamen, rechtwinklig zu den Rotationsachsen Rz verlaufenden Referenzlinie 46 liegen (Fig. 3).

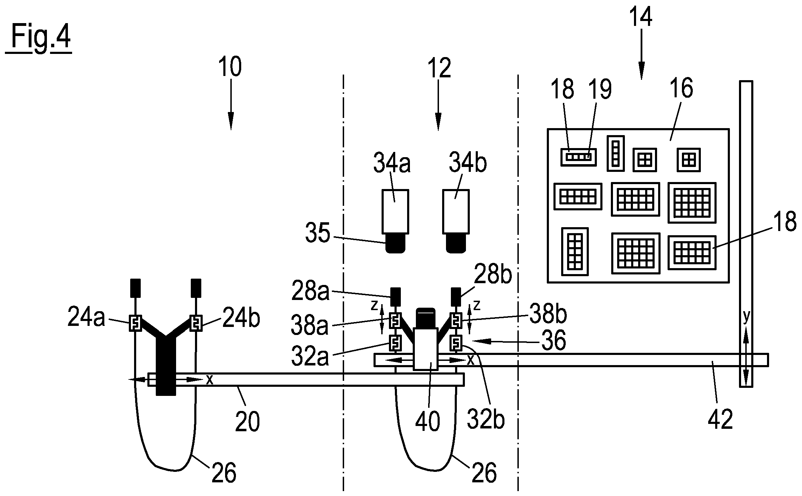

Die Bestückungseinheit 36 wird anschließend oder noch während des Ausrichtprozesses zu der Ausrichtstation 12 bewegt. Die beiden Enden der elektrischen Leitung 26 mit den Kontaktteilen 28a, 28b werden dort von den Ausrichtgreifern 32a, 32b an die Bestückungsgreifer 38a, 38b übergeben, wie dies in Fig. 4 gezeigt ist. Die Übergabe wird unter Vermeidung einer Verdrehung der Kontaktteile 28a, 28b durchgeführt. Mit Hilfe der Kameras 34a, 34b werden eventuelle Abweichungen der Positionen der Kontaktteile 28a, 28b in einer rechtwinklig zu den Rotationsachsen Rz verlaufenden x-y-Ebene relativ zu jeweiligen Referenzpositionen ermittelt.

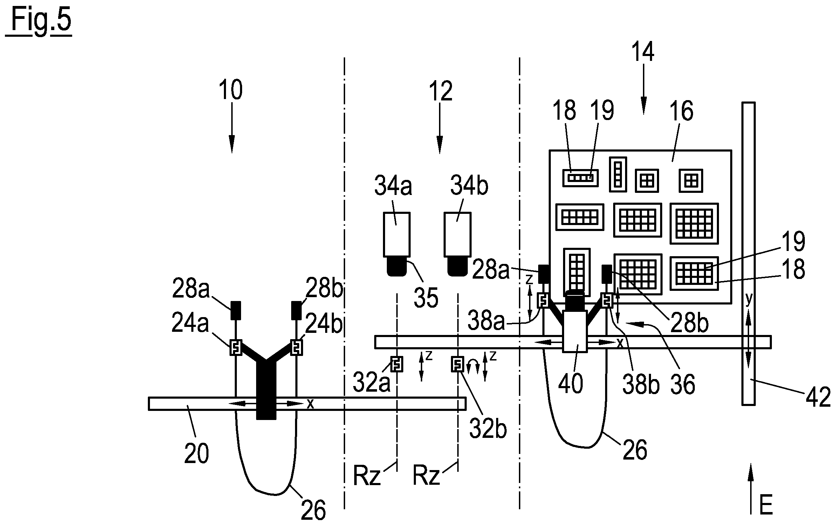

Die Bestückungseinheit 36 wird dann mitsamt der elektrischen Leitung 26 mittels des zweiten Positionierungssystems 42 in der x-y-Ebene vor dem gewünschten Steckergehäuse 18 positioniert (Fig. 5). Die Kamera 40 der Bestückungseinheit 36 ermittelt die genaue Position einschließlich etwaiger geringfügiger Verdrehungen des betreffenden Steckergehäuses 18 relativ zu einer vorgegebenen, der Kamera 40 zugeordneten Referenzposition. Die ermittelten Positionsabweichungen und Verdrehungen werden in einer nicht dargestellten Steuereinrichtung temporär gespeichert und für Bestückungsvorgänge an weiteren Kavitäten 19 des betreffenden Steckergehäuses 18 verwendet. Die Positionen der Kavitäten 19 eines bestimmten Steckergehäuses 18 relativ zu einer Referenzposition werden einer übergeordneten Datenbank entnommen.

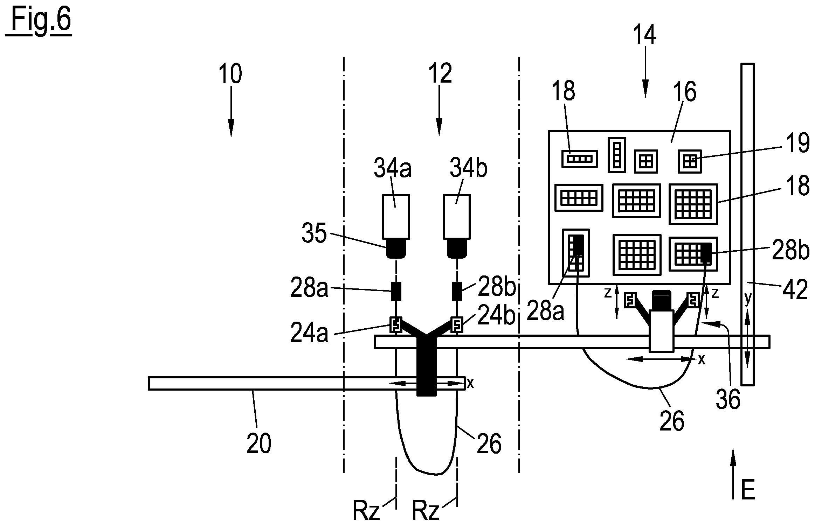

Aufgrund einer vor Betriebsbeginn durchgeführten, nachfolgend noch genauer zu beschreibenden Kalibrierung der Bestückungsvorrichtung sind die genauen Positionen der Spitzen der Kontaktteile 28a, 28b relativ zu der Referenzposition der Kamera 40 bekannt. Die Bestückungseinheit 36 wird nun mittels des zweiten Positionierungssystems 42 derart in der x-y-Ebene positioniert, dass das im Bild links befindliche Kontaktteil 28a vor der zu bestückenden Kavität 19 angeordnet ist. Durch eine Bewegung des zugehörigen Bestückungsgreifers 38a in einer Einführrichtung E wird das Kontaktteil 28a in die Kavität 19 eingeführt und gegebenenfalls mit dieser verrastet. Der gleiche Vorgang wird mit dem anderen Kontaktteil 28b und der diesem entsprechenden Kavität 19 wiederholt, sodass der in Fig. 6 dargestellte Zustand hergestellt ist. Wie in Fig. 5 und 6 erkennbar verläuft die Einführrichtung E parallel zu den Rotationsachsen Rz.

Für die verschiedenen Steckergehäuse 18, die an dem Halter 16 fixiert sind, wird jeweils lediglich beim ersten Kontaktteil 28a, 28b die Position des Steckergehäuses 18 durch die Kamera 40 erfasst. Bei allen weiteren Kontaktteilen 28a, 28b für das betreffende Steckergehäuse 18 werden die temporär gespeicherten Positionsdaten verwendet.

Während des Bestückungsvorgangs wird mittels der Zuführungsgreifer 24a, 24b eine weitere elektrische Leitung 26 mit daran angebrachten Kontaktteilen 28a, 28b bereitgestellt und zu der Ausrichtstation 12 transportiert und der Prozess beginnt von vorn. Bei Bedarf ist es möglich, an der Ausrichtstation 12 nur einen einzelnen Ausrichtgreifer 32a und nur eine Kamera 34a zu verwenden.

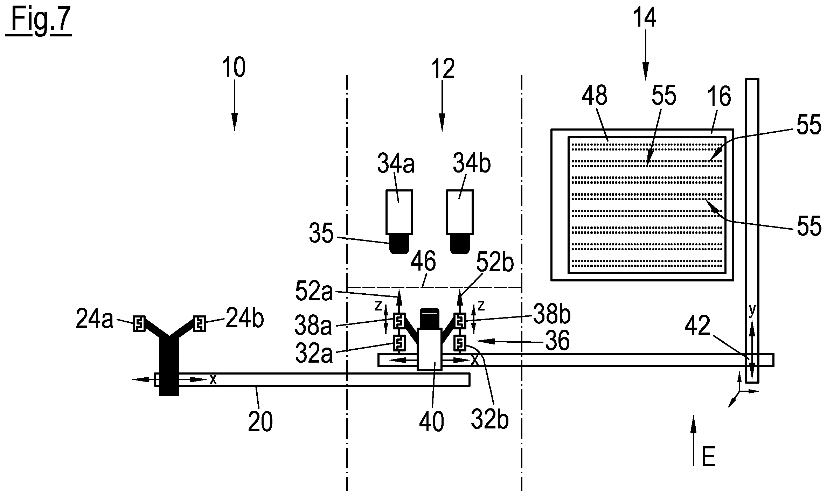

Fig. 7 verdeutlicht ein Kalibrierverfahren für die erfindungsgemäße Bestückungsvorrichtung, welches unter Verwendung eines Markierungsträgers 48 und zweier Markierungsmittel 52a, 52b durchgeführt wird. Im Rahmen dieses Kalibrierverfahrens wird zunächst der Markierungsträger 48, bei welchem es sich beispielsweise um ein Papier- oder Folienelement handeln kann, an dem Halter 16 befestigt. Mittels der Bestückungsgreifer 38a, 38b werden anstelle von Enden der elektrischen Leitung 26 jeweilige Markierungsmittel 52a, 52b gegriffen. Die Markierungsmittel 52a, 52b sind in Fig. 7 allgemein als Pfeile dargestellt und können in der Praxis beispielsweise als Stifte, Nadeln, Laserköpfe oder Thermoelemente ausgeführt sein. Der erste Bestückungsgreifer 38a wird entlang einer horizontalen Linie bewegt. In einem gleichmäßigen Abstand von beispielsweise 10 mm wird die Bewegung jeweils angehalten und der Bestückungsgreifer 38a wird in der Einführrichtung E auf den Markierungsträger 48 zu bewegt, bis die Spitze des Markierungsmittels 52a diesen kontaktiert und dadurch einen Markierungspunkt 55 setzt. Anschließend wird mit veränderter Y-Position eine weitere Zeile von Markierungspunkten 55 erstellt. Das zeilenweise Setzen von Markierungspunkten 55 wird so oft wiederholt, bis der komplette Markierungsträger 48 wie dargestellt von einem rasterartigen Punktefeld bedeckt ist.

Nach dem Setzen aller Markierungspunkte 55 wird die Kamera 40 der Bestückungseinheit 36 mittels des zweiten Positionierungssystems 42 nacheinander zu den einzelnen Markierungspunkten 55 hin bewegt und die Positionen der Markierungspunkte 55 auf dem Markierungsträger 48 werden aus der Verfahrstellung des zweiten Positionierungssystems 42 sowie der Position des Markierungspunkts 55 in dem aufgenommenen Bild ermittelt. Die so ermittelten Positionen der Markierungspunkte 55 werden gemeinsam mit den Verfahrkoordinaten des zweiten Positionierungssystems 42 in einer Speichereinrichtung abgelegt. Anschließend wird das Kalibrierverfahren mit dem zweiten Bestückungsgreifer 38b und dem von diesem gegriffenen Markierungsmittel 52b wiederholt.

Bei einem nachfolgenden Normalbetrieb der Bestückungsvorrichtung können aus den Positionen der Steckergehäuse 18 auf dem Halter 16 unter Verwendung der gespeicherten Daten die entsprechenden Verfahrkoordinaten des zweiten Positionierungssystems 42 ermittelt werden. Zwischenwerte können hierbei durch geeignete mathematische Verfahren, beispielsweise durch ein Interpolationsverfahren, ermittelt werden. Eventuelle Abweichungen von einer orthogonalen und linearen Bewegung der Bestückungseinheit 36, welche zum Beispiel zu einer trapezförmigen, kissenförmigen oder tonnenförmigen Verzerrung des rasterartigen Punktefelds führen, sind durch die Kalibrierungsdatei erfasst und können steuerungstechnisch entsprechend kompensiert werden.

Insgesamt ermöglicht die Erfindung eine besonders zuverlässige und schnelle Bestückung von Steckergehäusen 18 mit elektrischen Leitungen 26.

### Bezugszeichenliste

- 10: Zuführungsstation
- 12: Ausrichtstation
- 14: Bestückungsstation
- 16: Halter
- 18: Steckergehäuse
- 19: Kavität
- 20: erstes Positionierungssystem
- 24a, 24b: Zuführungsgreifer
- 26: elektrische Leitung
- 28a, 28b: Kontaktteil
- 32a, 32b: Ausrichtgreifer
- 34a, 34b: Kamera
- 35: Objektiv
- 36: Bestückungseinheit
- 38a, 38b: Bestückungsgreifer
- 40: Kamera
- 42: zweites Positionierungssystem
- 44a, 44b: vordere Stirnseite
- 46: Referenzlinie
- 48: Markierungsträger
- 52a, 52b: Markierungsmittel

- Rz: Rotationsachse
- E: Einführrichtung

## Patentansprüche

1. Verfahren zum automatischen Bestücken eines Steckergehäuses (18) mit einem an einer elektrischen Leitung (26) angebrachten Kontaktteil (28a, 28b), wobei das Steckergehäuse (18) an einem Halter (16) fixiert wird und das Kontaktteil (28a, 28b) mittels eines beweglichen Greifers (38a, 38b) in eine Kavität (19) des Steckergehäuses (18) eingeführt wird,
wobei
vor dem Einführen des Kontaktteils (28a, 28b) in die Kavität (19) ein Ausrichtprozess durchgeführt wird, welcher folgende Schritte umfasst:
(i) Halten des Kontaktteils (28a, 28b), direkt oder an der elektrischen Leitung (26), mittels des Greifers (38a, 38b) oder eines weiteren Greifers (32a, 32b);
(ii) Ermitteln einer tatsächlichen Drehstellung des gehaltenen Kontaktteils (28a, 28b) in Bezug auf eine parallel zu einer Einführrichtung (E) verlaufende Rotationsachse (Rz);
(iii) Vergleichen der ermittelten tatsächlichen Drehstellung mit einer durch die Beschaffenheit und die Anordnung des Steckergehäuses (18) vorgegebenen Drehstellung; und
(iv) Durchführen einer Drehstellungskorrektur mittels des das Kontaktteil (28a, 28b) haltenden Greifers (32a, 32b) beruhend auf dem Ergebnis des Vergleichs **dadurch gekennzeichnet, dass**
das Halten des Kontaktteils (28a, 28b) in Schritt (i) sowie das Durchführen der Drehstellungskorrektur in Schritt (iv) mittels eines drehbahren Ausrichtgreifers (32a, 32b) durchgeführt wird, der von dem zum Einführen des Kontaktteils (28a, 28b) in die Kavität (9) vorgesehenen Greifer (38a, 38b) getrennt ist, wobei das Kontaktteil (28a, 28b) nach dem Durchführen der Drehstellungskorrektur in Schritt (iv) unter Vermeidung einer weiteren Verdrehung von dem Ausrichtgreifer (32a, 32b) an dem zu Einführen des Kontaktteils (28a, 28b) in die Kavität (19) vorgesehenen Greifer (38a, 38b) übergeben wird.

2. Verfahren nach Anspruch 1,
**dadurch gekennzeichnet, dass**
das Ermitteln der tatsächlichen Drehstellung des Kontaktteils (28a, 28b) in Schritt (ii) mittels einer auf das gehaltene Kontaktteil (28a, 28b) gerichteten Bilderfassungseinrichtung (34a, 34b) durchgeführt wird.

3. Verfahren nach Anspruch 2,
**dadurch gekennzeichnet, dass**
ein Objektiv (35) der Bilderfassungseinrichtung (34a, 34b) auf eine der elektrischen Leitung (26) abgewandte Stirnseite (44a, 44b) des gehaltenen Kontaktteils (28a, 28b) fokussiert wird.

4. Verfahren nach einem der vorstehenden Ansprüche,
**dadurch gekennzeichnet, dass**
der Ausrichtprozess ferner den folgenden Schritt umfasst:
(v) Durchführen einer Tiefenstellungskorrektur mittels des das Kontaktteil (28a, 28b) haltenden Greifers (32a, 32b), falls eine tatsächliche Tiefenstellung des gehaltenen Kontaktteils (28a, 28b), welche eine bezüglich der Rotationsachse (Rz) axiale Position einer der elektrischen Leitung (26) abgewandten Stirnseite (44a, 44b) des Kontaktteils (28a, 28b) angibt, von einer vorgegebenen Referenz-Tiefenstellung abweicht.

5. Verfahren nach einem der vorstehenden Ansprüche,
**dadurch gekennzeichnet, dass**
das Einführen des Kontaktteils (28a, 28b) in die Kavität (19) einerseits und der Ausrichtprozess andererseits an räumlich voneinander getrennten Stationen (12, 14) einer gemeinsamen Bestückungsvorrichtung durchgeführt wird.

6. Verfahren nach Anspruch 5,
**dadurch gekennzeichnet, dass**
während des Durchführens des Ausrichtprozesses an der einen Station (12) ein zuvor ausgerichtetes Kontaktteil (28a, 28b) an der anderen Station (14) in eine Kavität (19) eines Steckergehäuses (28a, 28b) eingeführt wird.

7. Verfahren nach einem der vorstehenden Ansprüche,
**dadurch gekennzeichnet, dass**
während des Durchführens des Ausrichtprozesses ein nachfolgend auszurichtendes weiteres an einer elektrischen Leitung (26) angebrachtes Kontaktteil (28a, 28b) mittels eines beweglichen Zuführungsgreifers (24a, 24b) von einer Kontaktteilzufuhr entnommen und in eine Bereitstellungsposition gebracht wird.

8. Verfahren nach einem der vorstehenden Ansprüche,
**dadurch gekennzeichnet, dass**
in Schritt (i) mittels eines Mehrfachgreifers wenigstens zwei Kontaktteile (28a, 28b) gleichzeitig gehalten werden, welche in Schritt (iv) mittels des Mehrfachgreifers einer gemeinsamen Drehstellungskorrektur unterzogen werden.

9. Vorrichtung zum automatischen Bestücken eines Steckergehäuses (18) mit einem an einer elektrischen Leitung (26) angebrachten Kontaktteil (28a, 28b), umfassend einen Halter (16) zum Fixieren des Steckergehäuses (18) und einen beweglichen Greifer (38a, 38b) zum Einführen des Kontaktteils (28a, 28b) in eine Kavität (19) des Steckergehäuses (18),
mit
eine Ausrichtstation (12), welche umfasst:
- wenigstens einen Ausrichtgreifer (32a, 32b), welcher zum Halten des Kontaktteils (28a, 28b), direkt oder an der elektrischen Leitung (26), und zum Drehen des gehaltenen Kontaktteils (28a, 28b) um eine parallel zu einer Einführrichtung (E) verlaufende Rotationsachse (Rz) ausgebildet ist;
- eine Bilderfassungseinrichtung (34a, 34b) zum Ermitteln einer tatsächlichen Drehstellung eines von dem Ausrichtgreifer (32a, 32b) gehaltenen Kontaktteils (28a, 28b) in Bezug auf die Rotationsachse (Rz); und
- eine Steuereinrichtung, welche dazu ausgebildet ist, die ermittelte tatsächliche Drehstellung mit einer durch die Beschaffenheit und die Anordnung des Steckergehäuses (18) vorgegebenen Drehstellung zu vergleichen und den Ausrichtgreifer (32a, 32b) derart anzusteuern, dass dieser beruhend auf dem Ergebnis des Vergleichs eine korrigierende Drehbewegung ausführt,
**dadurch gekennzeichnet, dass**
der Ausrichtgreifer (32a, 32b) zusätzlich zu dem zum Einführen des Kontaktteils (28a, 28b) in die Kavität (19) vorgesehenen Greifer (38a, 38b) vorgesehen ist.

10. Vorrichtung nach Anspruch 9,
**dadurch gekennzeichnet, dass**
der Ausrichtgreifer (32a, 32b) zum Drehen des gehaltenen Kontaktteils (28a, 28b) um wenigstens 90°, bevorzugt um wenigstens 180°, ausgebildet ist, und/oder dass
der Ausrichtgreifer (32a, 32b) entlang der Rotationsachse (Rz) und/oder rechtwinklig zu der Rotationsachse (Rz) verschiebbar ist, vorzugsweise mittels eines Linearpositionierungssystems.

11. Vorrichtung nach einem der Ansprüche 9 oder 10,
**dadurch gekennzeichnet, dass**
der Ausrichtgreifer (32a, 32b) zum gemeinsamen Halten und Drehen von wenigstens zwei Kontaktteilen (28a, 28b) ausgebildet ist, insbesondere wobei jedem der gehaltenen Kontaktteile (28a, 28b) eine eigene Bilderfassungseinrichtung (34a, 34b) zugeordnet ist.

12. Vorrichtung nach einem der Ansprüche 9 bis 11,
**dadurch gekennzeichnet, dass**
die Bilderfassungseinrichtung (34a, 34b) derart angeordnet ist, dass sie von einer der elektrischen Leitung (26) abgewandten Seite aus auf das von dem Ausrichtgreifer (32a, 32b) gehaltene Kontaktteil (28a, 28b) gerichtet ist.

13. Vorrichtung nach einem der Ansprüche 9 bis 12,
**dadurch gekennzeichnet, dass**
eine weitere Bilderfassungseinrichtung (40) zum Ermitteln der Position des Steckergehäuses (18) relativ zu einer vorgegebenen Referenzposition vorgesehen ist, wobei der bewegliche Greifer (38a, 38b) und die weitere Bilderfassungseinrichtung (40) eine für eine gemeinsame Bewegung ausgebildete Bestückungseinheit (36) bilden.

## Claims

1. Method for automatically assembling a connector housing (18) with a contact member (28a, 28b) attached to an electrical line (26), wherein the connector housing (18) is fixed to a holder (16) and the contact member (28a, 28b) is inserted into a cavity (19) of the connector housing (18) by means of a movable gripper (38a, 38b),
wherein
prior to inserting the contact member (28a, 28b) into the cavity (19), an alignment process is carried out comprising the following steps:
(i) holding the contact member (28a, 28b), directly or on the electrical line (26), by means of the gripper (38a, 38b) or a further gripper (32a, 32b);
(ii) determining an actual rotational position of the held contact member (28a, 28b) in respect to a rotational axis (Rz) extending parallel to an insertion direction (E);
(iii) comparing the determined actual rotational position with a rotational position predetermined by the structure and arrangement of the connector housing (18); and
(iv) performing a rotational position correction by means of the gripper (32a, 32b) holding the contact member (28a, 28b) based on the result of the comparison, **characterized in that**
holding of the contact member (28a, 28b) in step (i) as well as performing the rotational position correction in step (iv) is performed by means of a rotatable alignment gripper (32a, 32b) which is separated from the gripper (38a, 38b) provided for insertion of the contact member (28a, 28b) into the cavity (19) wherein the contact member (28a, 28b), after performing the rotational position correction in step (iv) while avoiding further rotation, is passed from the alignment gripper (32a, 32b) to the gripper (38a, 38b) provided for insertion of the contact member (28a, 28b) into the cavity (19).

2. Method according to claim 1,
**characterized in that**
the determination of the actual rotational position of the contact member (28a, 28b) in step (ii) is performed by means of an image capturing device (34a, 34b) directed to the held contact member (28a, 28b).

3. Method according to claim 2,
**characterized in that**
an objective (35) of the image capturing device (34a, 34b) is focused on an end face (44a, 44b) of the of the held contact member (28a, 28b) facing away from the electrical line (26).

4. Method according to one of the preceding claims,
**characterized in that**
the alignment process further comprises the following step:
(v) performing a depth position correction by means of the gripper (32a, 32b) holding the contact member (28a, 28b) if an actual depth position of the held contact member (28a, 28b), which, in respect to the rotational axis (Rz), indicates an axial position of an end face (44a, 44b) of the contact member (28a, 28b) facing away from the electrical line (26), deviates from a predetermined reference depth position.

5. Method according to one of the preceding claims,
**characterized in that**
the insertion of the contact member (28a, 28b) into the cavity (19) on the one hand and the alignment process on the other hand are performed at spatially separated stations (12, 14) of a common assembling device.

6. Method according to claim 5,
**characterized in that**
during execution of the alignment process at one station (12) a previously aligned contact member (28a, 28b) is inserted into a cavity (19) of a connector housing (28a, 28b) at the other station (14).

7. Method according to one of the preceding claims,
**characterized in that**
during execution of the alignment process, a further contact member (28a, 28b) to be aligned, attached to on an electrical line (26), is taken from a contact member feed by means of a movable feed gripper (24a, 24b) and is brought into a provisioning position.

8. Method according to one of the preceding claims,
**characterized in that**
in step (i) at least two contact members (28a, 28b) are held simultaneously by means of a multi-gripper, which in step (iv) are subjected to a common rotational position correction by means of the multi-gripper.

9. Apparatus for automatically assembling a connector housing (18) with a contact member (28a, 28b) attached to an electrical line (26), comprising a holder (16) for fixing the connector housing (18) and a movable gripper (38a, 38b) for inserting the contact member (28a, 28b) into a cavity (19) of the connector housing (18),
with
an alignment station (12) comprising:
- at least one alignment gripper (32a, 32b), which is adapted for holding the contact member (28a, 28b), directly or on the electrical line (26), and for rotating the held contact member (28a, 28b) about a rotational axis (Rz) extending parallel to an insertion direction (E);
- an image capturing device (34a, 34b) for determining an actual rotational position of a contact member (28a, 28b) held by the alignment gripper (32a, 32b) in respect to the rotational axis (Rz); and
- a control device which is adapted to compare the determined actual rotational position with a rotational position predetermined by the structure and arrangement of the connector housing (18) and to control the alignment gripper (32a, 32b) such that it performs a corrective rotational movement based on the result of the comparison,
**characterized in that**
the alignment gripper (32a, 32b) is provided in addition to the gripper (38a, 38b) provided for insertion of the contact member (28a, 28b) into the cavity (19).

10. Apparatus according to claim 9,
**characterized in that**
the alignment gripper (32a, 32b) is adapted for rotating the held contact member (28a, 28b) by at least 90°, preferably by at least 180°, and/or that the alignment gripper (32a, 32b) is moveable along the rotational axis (Rz) and/or at right angles to the rotational axis (Rz), preferably by means of a linear positioning system.

11. Apparatus according to one of claims 9 or 10,
**characterized in that**
the alignment gripper (32a, 32b) is adapted for common holding and rotating of at least two contact members (28a, 28b), in particular wherein each of the held contact members (28a, 28b) is assigned its own image capturing device (34a, 34b).

12. Apparatus according to one of claims 9 to 11,
**characterized in that**
the image capturing device (34a, 34b) is arranged such that it is directed from a side facing away from of the electrical line (26) to the contact member (28a, 28b) held by the alignment gripper (32a, 32b).

13. Apparatus according to one of claims 9 to 12,
**characterized in that**
a further image capturing device (40) is provided for determining the position of the connector housing (18) relative to a predetermined reference position, wherein the movable gripper (38a, 38b) and the further image capturing device (40) form an assembly unit (36) adapted for common movement.

## Revendications

1. Procédé d'équipement automatique d'un boîtier de fiche (18) avec une pièce de contact (28a, 28b) montée sur une ligne électrique (26), dans lequel le boîtier de fiche (18) est fixé sur un élément de retenue (16) et la pièce de contact (28a, 28b) est introduite dans une cavité (19) du boîtier de fiche (18) au moyen d'un préhenseur mobile (38a, 38b),
dans lequel
avant d'introduire la pièce de contact (28a, 28b) dans la cavité (19), on effectue une opération d'orientation qui comprend les étapes suivantes consistant à :
(i) retenir la pièce de contact (28a, 28b) directement ou sur la ligne électrique (26) au moyen du préhenseur (38a, 38b) ou d'un autre préhenseur (32a, 32b) ;
(ii) déterminer une position de rotation réelle de la pièce de contact retenue (28a, 28b) par rapport à un axe de rotation (Rz) parallèle à une direction d'introduction (E) ;
(iii) comparer la position de rotation réelle déterminée à une position de rotation donnée par la nature et par l'agencement du boîtier de fiche (18) ; et
(iv) effectuer une correction de la position de rotation au moyen du préhenseur (32a, 32b) retenant la pièce de contact (28a, 28b) en se basant sur le résultat de la comparaison,
**caractérisé en ce que**
la retenue de la pièce de contact (28a, 28b) dans l'étape (i) ainsi que la mise en oeuvre de la correction de la position de rotation dans l'étape (iv) s'effectuent au moyen d'un préhenseur d'orientation rotatif (32a, 32b) qui est séparé du préhenseur (38a, 38b) prévu pour introduire la pièce de contact (28a, 28b) dans la cavité (19), et après avoir effectué la correction de la position de rotation dans l'étape (iv) la pièce de contact est remise du préhenseur d'orientation (32a, 32b) au préhenseur (38a, 38b), prévu pour introduire la pièce de contact (28a, 28b) dans la cavité (19), en évitant une poursuite de la rotation.

2. Procédé selon la revendication 1,
**caractérisé en ce que**
la détermination de la position de rotation réelle de la pièce de contact (28a, 28b) dans l'étape (ii) est effectuée à l'aide d'un moyen d'acquisition d'images (34a, 34b) dirigé vers la pièce de contact retenue (28a, 28b).

3. Procédé selon la revendication 2,
**caractérisé en ce que**
un objectif (35) du moyen d'acquisition d'images (34a, 34b) est focalisé sur un côté frontal (44a, 44b) de la pièce de contact retenue (28a, 28b), détourné de la ligne électrique (26).

4. Procédé selon l'une des revendications précédentes,
**caractérisé en ce que**
l'opération d'orientation comprend en outre l'étape suivante :
(v) effectuer une correction de la position en profondeur à l'aide du préhenseur (32a, 32b) retenant la pièce de contact (28a, 28b) si une position en profondeur réelle de la pièce de contact retenue (28a, 28b), qui indique une position, axiale par rapport à l'axe de rotation (Rz), d'un côté frontal (44a, 44b) de la pièce de contact (28a, 28b), détourné de la ligne électrique (26), s'écarte d'une position en profondeur de référence donnée.

5. Procédé selon l'une des revendications précédentes,
**caractérisé en ce que**
l'introduction de la pièce de contact (28a, 28b) dans la cavité (19) d'une part et l'opération d'orientation d'autre part sont effectuées dans des stations (12, 14) séparées dans l'espace d'un dispositif d'équipement commun.

6. Procédé selon la revendication 5,
**caractérisé en ce que**
pendant la mise en oeuvre de l'opération d'orientation dans l'une des stations (12), une pièce de contact (28a, 28b) orientée préalablement dans l'autre station (14) est introduite dans une cavité (19) d'un boîtier de fiche (28a, 28b).

7. Procédé selon l'une des revendications précédentes,
**caractérisé en ce que**
pendant la mise en oeuvre de l'opération d'orientation, une autre pièce de contact (28a, 28b) orientée à la suite et montée sur une ligne électrique (26) est prélevée d'une alimentation de pièce de contact et amenée dans une position de préparation au moyen d'un préhenseur d'alimentation mobile (24a, 24b).

8. Procédé selon l'une des revendications précédentes,
**caractérisé en ce que**
dans l'étape (i), au moyen d'un préhenseur multiple, aux moins deux pièces de contact (28a, 28b) sont retenues simultanément, qui sont soumises à une correction commune de la position de rotation dans l'étape (iv) au moyen du préhenseur multiple.

9. Dispositif d'équipement automatique d'un boîtier de fiche (18) avec une pièce de contact (28a, 28b) montée sur une ligne électrique (26), comportant un élément de retenue (16) pour fixer le boîtier de fiche (18) et un préhenseur mobile (38a, 38b) pour introduire la pièce de contact (28a, 28b) dans une cavité (19) du boîtier de fiche (18), comportant une station d'orientation (12) qui comprend :
- au moins un préhenseur d'orientation (32a, 32b) qui est réalisé pour retenir la pièce de contact (28a, 28b) directement ou sur la ligne électrique (26) et pour faire tourner la pièce de contact retenue (28a, 28b) autour d'un axe de rotation (Rz) qui s'étend parallèlement à une direction d'introduction (E) ;
- un moyen d'acquisition d'images (34a, 34b) pour déterminer une position de rotation réelle d'une pièce de contact (28a, 28b), retenue par le préhenseur d'orientation (32a, 32b), par rapport à l'axe de rotation (Rz) ; et
- une unité de commande qui est réalisée pour comparer la position de rotation réelle déterminée à une position de rotation donnée par la nature et par l'agencement du boîtier de fiche (18) et pour piloter le préhenseur d'orientation (32a, 32b) de telle sorte que celui-ci exécute un mouvement de rotation de correction en se basant sur le résultat de la comparaison,
**caractérisé en ce que**
le préhenseur d'orientation (32a, 32b) est prévu en supplément au préhenseur (38a, 38b) prévu pour introduire la pièce de contact (28a, 28b) dans la cavité (19).

10. Dispositif selon la revendication 9,
**caractérisé en ce que**
le préhenseur d'orientation (32a, 32a) est réalisé pour faire tourner la pièce de contact retenue (28a, 28b) d'au moins 90°, de préférence d'au moins 180°, et/ou **en ce que**
le préhenseur d'orientation (32a, 32b) est mobile le long de l'axe de rotation (Rz) et/ou à angle droit par rapport à l'axe de rotation (Rz), de préférence au moyen d'un système de positionnement linéaire.

11. Dispositif selon l'une des revendications 9 ou 10,
**caractérisé en ce que**
le préhenseur d'orientation (32a, 32b) est réalisé pour retenir et faire tourner conjointement au moins deux pièces de contact (28a, 28b), et en particulier un moyen d'acquisition d'images (34a, 34b) propre est associé à chacune des pièces de contact retenues (28a, 28b).

12. Dispositif selon l'une des revendications 9 à 11,
**caractérisé en ce que**
le moyen d'acquisition d'images (34a, 34b) est agencé de manière à être dirigé depuis un côté détourné de la ligne électrique (26) vers la pièce de contact (28a, 28b) retenue par le préhenseur d'orientation (32a, 32b).

13. Dispositif selon l'une des revendications 9 à 11,
**caractérisé en ce que**
il est prévu un autre moyen d'acquisition d'images (40) pour déterminer la position du boîtier de fiche (18) par rapport à une position de référence donnée, le préhenseur mobile (38a, 38b) et l'autre moyen d'acquisition d'images (40) formant une unité d'équipement (36) réalisée pour un mouvement commun.
